# EUROPEAN PATENT SPECIFICATION

(11) **EP 1 387 485 B1**
(45) Date of publication and mention of the grant of the patent: **30.04.2008**
(21) Application number: 02255396.0
(22) Date of filing: 01.08.2002
(51) Int. Cl.: H03F 1/02

(54) **Circuit for power amplification**
SCHALTUNG FÜR LEISTUNGSVERSTÄRKER
Circuit pour l'amplification de puissance

(43) Date of publication of application: 04.02.2004
(73) Proprietor: TELEFONAKTIEBOLAGET LM ERICSSON (publ), 164 83 Stockholm (SE)
(72) Inventor: Brandt, Per-Olof, 234 31 Lomma (SE)
(74) Representative: Vigars, Christopher Ian

(56) References cited:
- US-A- 4 924 191
- US-A- 5 426 641
- US-A- 5 673 001
- US-A- 6 043 707

## Description

### Technical Field of the Invention

The present invention relates to a power control circuit and method, and in particular to the control of output power of a high frequency power amplifier.

### Description of the Related Art

In modern telecommunication systems, radio frequency (RF) power amplifiers are used to control output power of mobile devices (such as cellular telephones, cordless telephones, two-way pagers, wireless LAN, AM/FM analogue transmitters) prior to, and during, signal transmission. These RF power amplifiers typically generate an output power in the range of 50mW to 3W. Known RF power amplifiers can control output power at a RF load (which is generally an antenna) via biasing an output transistor.

Generally in RF power amplifiers, impedance at the output transistor must match the nominal impedance of the load in order to avoid problems such as unwanted standing waves (resulting from signal reflection at the load) in the apparatus. Efficient antenna operation requires that the antenna is matched to the circuit service, to ensure maximum energy transfer. The quality of system matching is measured in terms of a parameter known as voltage standing wave ratio (VSWR). This parameter can be determined for frequencies at which a particular system operates. Optimum operation in a RF power amplifier requires a 1:1 VSWR at all relevant frequencies. Unfortunately, many conventional antennas exhibit a high VSWR (for example, greater than 3:1) which adversely affects efficiency, especially in wideband antennas, unless some form of compensatory matching network is used. Use of such compensatory matching networks is undesirable because they tend to decrease transmission power available and slow the operation of the system.

The impedance of a load such as an antenna varies with motion and position and thus, impedance variation is common for mobile devices. The impedance variation results in a voltage swing across the collector electrode of the output transistor of the RF power amplifier. For example, a RF power amplifier driving a cellular telephone antenna with 50 Ohms nominal impedance may, at times, be required to drive a high output transistor impedance, which could lead to a VSWR as high as 20:1.

Substantially mismatched loads (and hence a high VSWR) can lead to a degradation of the RF power amplifier. This degradation, or even transistor failure, occurs as a result of exceeding the collector-emitter voltage and collector current that can safely be applied to a bipolar transistor (here, the output transistor) within the constraints of the 'secondary breakdown' effect.

The output transistor is not able to draw d.c. current (as a capacitor is used to remove the d.c. component) and so the output bias circuitry provides increased bias current, which leads to increased input power to the output transistor. Where a system is experiencing high VSWR and high load impedance, and hence a large voltage swing at the collector electrode of the output transistor, it is possible that negative gain can occur in the output amplifier.

United States Patent 5,455,968(Pham) discloses a variable power amplifier including a final stage amplification element. This element is coupled to a bias network which aims to provide stability where output mismatch conditions exceed 5:1 VSWR.

Japanese Patent JP 11284522 describes a system to maintain constant output power in a high frequency power amplifier. An output signal of a second amplifier is detected, processed and input to a first amplifier. The system involves the use of a directional coupler.

Therefore, it can be seen that it is desirable to control output power of an RF power amplifier where the impedance of the load is varying.

United States Patent 4,924,191 discloses a processor to optimise the operating point of each of a plurality of amplifying elements as a function of the amplifying element characteristics.

### Summary

According to a first aspect of the present invention, there is provided a method of controlling output from a power amplifier which has a driver stage and an output stage, the method comprising detecting a first and a second electrical parameter at an output of the output stage; processing the first parameter with a first reference signal to generate a controlled bias signal; processing the second parameter with a second reference signal to generate a bias reduction signal; feeding the controlled bias signal to a bias input of both the driver and the output stages, and feeding the bias reduction signal to the bias input of the driver stage to reduce the bias provided by the controlled bias signal.

According to a second aspect of the present invention there is provided an electrical circuit comprising: a power amplifier,the power amplifier comprising a driver stage and an output stage; an external control loop, the external control loop comprising: detection means for detecting a first electrical parameter at an output of the output stage; a first reference signal generator for producing a first reference signal; biasing means for receiving the first reference signal and for feeding a controlled bias signal to a bias input of both the driver and the output stages in response to the detected first electrical parameter and the first reference signal; a protection circuit, the protection circuit comprising: detection means for detecting a second electrical parameter at an output of the output stage; a second reference signal generator for producing a second reference signal; bias reduction means for receiving the second reference signal and for feeding a bias signal to the bias input of the driver stage, in response to the detected second electrical parameter and the second reference signal in order to reduce the controlled bias signal.

The power amplification circuit as described above can be utilised in a mobile telecommunications device.

Advantageously, the present invention mitigates problems associated with output power control in the prior art. Also, low voltage transistors (and other low voltage technologies) can be used and the invention be implemented on an integrated circuit using a minimum of components. Where high output mismatch conditions result in the circuit experiencing a high VSWR, the present invention functions to reduce the circuit output power variation.

Further advantage is obtained in that both the driver transistor and output transistor are protected from excessive voltage levels.

It is emphasised that the term 'comprises' or 'comprising' is used in this specification to specify the presence of stated features, integers, steps or components, but does not preclude the addition of one or more further features, integers, steps or components, or groups thereof.

### Brief Description of the Drawings

Figure 1 is a schematic diagram of a RF power amplifier;
Figure 2 is a schematic diagram of a RF power amplifier in accordance with an embodiment of the invention;
Figure 3 is a schematic diagram showing the RF power amplifier of Figure 2 in greater detail; and
Figure 4 is a flow chart showing the operational stages of the present invention.

### Detailed Description of the Embodiments

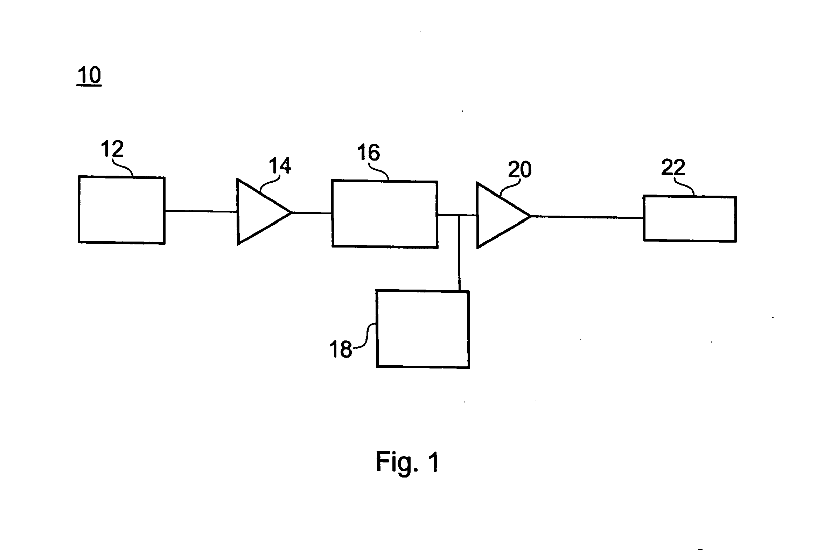

Figure 1 illustrates a RF power amplifier 10, in which a RF signal 12 is input to a driver transistor 14. The collector electrode of the driver transistor 14 is coupled to a capacitor 16, which, in turn is coupled to an output transistor 20. An output bias circuitry 18 is coupled to the base electrode of the output transistor 20. Finally, the collector electrode of the output transistor 20 is coupled to a RF load 22. Generally, the RF load 22 is an antenna.

In operation, the RF signal 12 is amplified by the driver transistor 14, and the capacitor 16 serves to remove any d.c. component (leaving only the a.c. component) of the amplified signal before it is input to the output transistor 20. An approximately constant bias current is output from the output bias circuitry 18 and functions to bias the output transistor 20 such that the output transistor collector current is controlled.

The capacitor 16 functions to match impedance in the circuit and can be replaced by any suitable impedance matching element.

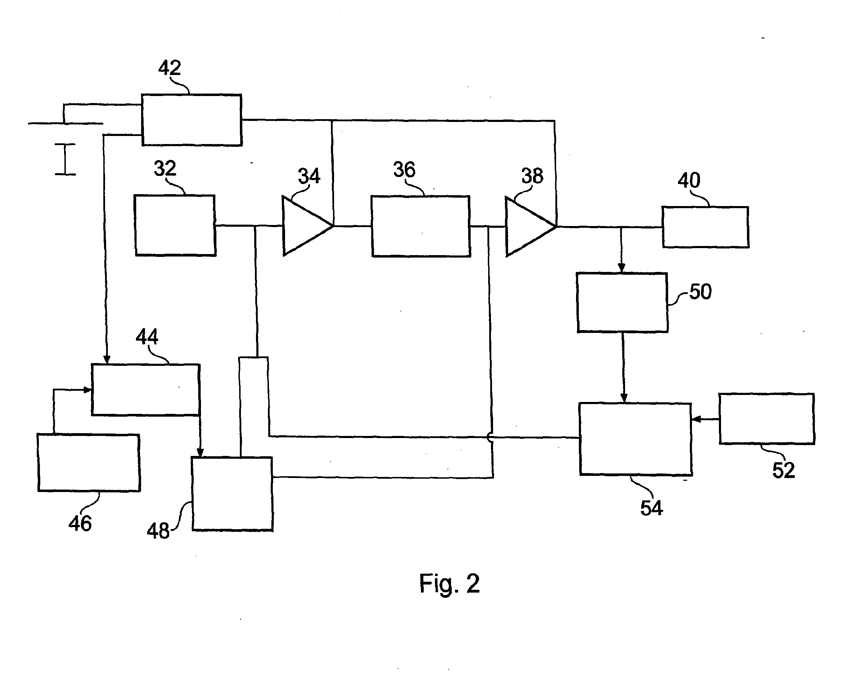

In Figure 2, a RF power amplifier is coupled to an external control loop and a protection circuit. Specifically, in the RF power amplifier a RF signal 32 is input to a driver transistor 34. The collector electrode of the driver transistor 34 is coupled to a capacitor 36 which, in turn is coupled to an output transistor 38. A collector electrode of the output transistor 38 is coupled to a RF load 40 (which is generally an antenna).

Alternatively, the capacitor 36 can be replaced by other suitable RF matching means (such as a capacitor and shunt element in series or a transformer) as determined by the impedance transfer characteristics required within the RF power amplifier.

The external control loop includes a d.c. current detector 42 which is connected to the RF power amplifier at the collector electrode of both the driver transistor 34 and the output transistor 38. The d.c. current detector 42 and a reference current 46 are coupled to a regulator 44, which regulator 44 is coupled to a bias control signal generator 48. The external control loop further comprises a connection from the bias control signal generator 48 to each of the base electrode of the driver transistor 34 and the base electrode of the output transistor 38.

The protection circuit comprises a voltage envelope detector 50 and a protection level reference 52 both coupled to a bias reduction circuit 54. The voltage envelope detector 50 is connected to the collector electrode of the output transistor 38 and also, the bias reduction circuit 54 is connected to the base electrode of the driver transistor 34.

In operation, the RF power amplifier functions in a similar manner to the RF power amplifier 10 of Figure 1. The d.c. current detector 42 detects any voltage swing (resulting from an impedance variation on the RF load 40) at the collector electrode of the output transistor 38.

The d.c. current detector 42 detects the d.c. current at the collector electrode of the output transistor 38. Generally, any alteration in this current is caused by an impedance variation on the RF load 40. The detected current is output from the d.c. current detector 42 and fed to the regulator 44 which processes the detected current in combination with the reference current 46. Where the detected current is lower than a predetermined threshold the regulator 44 produces a higher regulated output current and when the detected current is higher than a predetermined threshold the regulator 44 produces a lower regulated output current. The regulated output current is fed to the bias control signal generator 48 which provides a suitable bias current to the driver transistor 34 and the output transistor 38 to compensate for any impedance variation on the RF load 40.

The voltage envelope detector 50 detects the voltage envelope at the collector electrode of the output transistor 38. This signal is processed, in combination with a protection level reference signal 52, in the bias reduction circuit 54. The resulting signal is fed to the base electrode of the driver transistor 34 to ensure that a voltage swing at the output transistor 38 does not reach an excessive level.

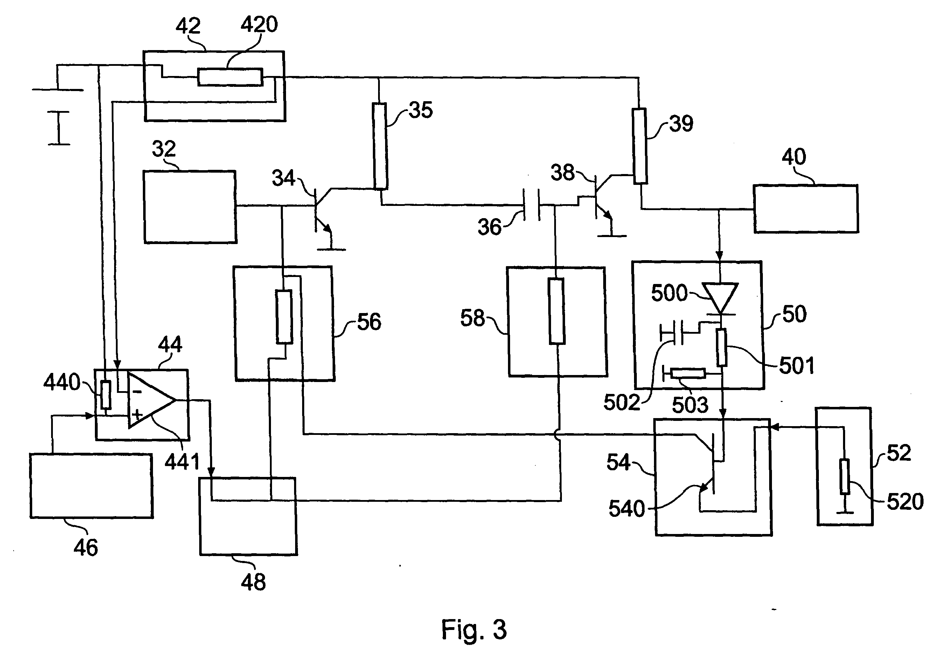

Figure 3 illustrates the RF power amplifier of Figure 2 in greater detail, but common reference numerals are employed where common elements are illustrated. Specifically, additional detail can be found where a first choke element 35 and a second choke element 39 are coupled between the d.c. current detector 42 and the driver transistor 34 and the output transistor 38, respectively.

In the external control loop, the d.c. current detector 42 includes a resistor 420 connected to the input line from the regulator 44. The regulator 44 is shown to include a resistor 440 and an AND gate 441.

In the protection circuit, the voltage envelope detector 50 includes a diode 500 and a first resistor 501 connected in series. A capacitor 502 is coupled between the output of the diode 500 and ground, and a second resistor 503 is coupled between the output of the first resistor 501 and ground. The protection level reference 52 includes a resistor 520 coupled between ground and the protection level reference output. This output is connected to an emitter electrode of a transistor 540 located within the bias reduction circuit 54. Additionally, a first resistor block 56 connected to the base electrode of driver transistor 34 and a second resistor block 58 connected to the base electrode of output transistor 38, are illustrated.

The operation of the circuit of Figure 3 is described above, in relation to Figure 2.

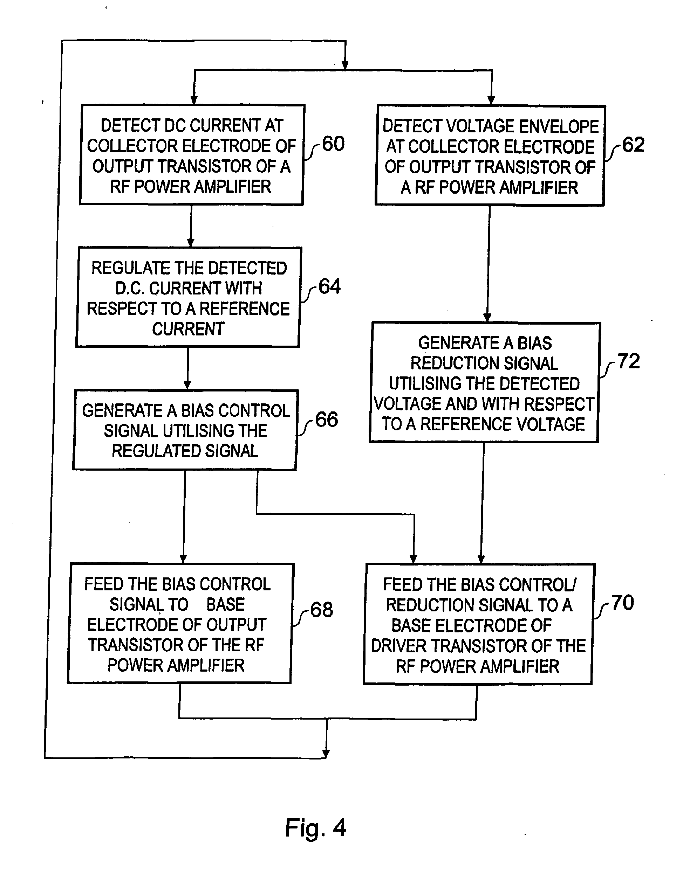

As shown in Figure 4, the first stages of operation of the present invention involve the detection 60 62 of two parameters (namely the d.c. current and the voltage envelope) at the collector electrode of the output transistor. The detected d.c. current is regulated 64 with respect to a reference current and then a bias control signal is generated 66 utilising the regulated signal. A control loop is completed when the bias control signal is fed 68 70 to the base electrode of each of the output transistor and the driver transistor.

Returning to the detected voltage envelope, a bias signal is generated 72 utilising the detected voltage envelope with respect to a reference voltage. A protection function is performed when the bias reduction signal is fed 70 to a base electrode of the driver transistor. Both the control loop function and the protection function are performed on a continuous basis during the operation of the RF power amplifier.

It will be apparent to the skilled person that the above described circuit architecture is not exhaustive and variations on this structure may be employed to achieve a similar result whilst employing the same inventive concept.

It can therefore be seen that the present invention provides a power amplification circuit which has significant advantages over conventional devices.

## Claims

1. A method of controlling output from a power amplifier (10) which has a driver stage (14) and an output stage (20), the method comprising:
detecting a first and a second electrical parameter at an output of the output stage (20);
processing the first parameter with a first reference signal to generate a controlled bias signal;
processing the second parameter with a second reference signal to generate a bias reduction signal;
feeding the controlled bias signal to a bias input of both the driver (14) and the output stages (20);
feeding the bias reduction signal to the bias input of the driver stage (14) to reduce the bias provided by the controlled bias signal such that said output of said power amplifier is protected.

2. The method of controlling output from a power amplifier as claimed in claim 1, wherein the first electrical parameter is an electrical current.

3. The method of controlling output from a power amplifier as claimed in claim 1, wherein the second electrical parameter is an output voltage envelope.

4. An electrical circuit comprising:
a power amplifier(10), the power amplifier (10) comprising a driver stage (34) and an output stage (38);
an external control loop, the external control loop comprising:
detection means (42) for detecting a first electrical parameter at an output of the output stage (38);
a first reference signal generator (44) for producing a first reference signal;
biasing means (48) for receiving the first reference signal and for feeding a controlled bias signal to a bias input of both the driver (34) and the output stages (38) in response to the detected first electrical parameter and the first reference signal;
a protection circuit, the protection circuit comprising:
detection means (50) for detecting a second electrical parameter at an output of the output stage (38);
a second reference signal generator (52) for producing a second reference signal;
bias reduction means (54) for receiving the second reference signal and for feeding a bias signal to the bias input of the driver stage (34), in response to the detected second electrical parameter and the second reference signal in order to reduce the controlled bias signal.

5. A mobile telecommunications device including the power amplification circuit as claimed in claim 4.

## Patentansprüche

1. Verfahren zum Steuern einer Ausgabe von einem Leistungsverstärker (10), welcher eine Treiberstufe (14) und eine Ausgangsstufe (20) hat, wobei das Verfahren enthält:
Erfassen eines ersten und eines zweiten elektrischen Parameters an einer Ausgabe von der Ausgangsstufe (20);
Verarbeiten des ersten Parameters mit einem ersten Referenzsignal, um ein gesteuertes Vorspann-Signal zu erzeugen;
Verarbeiten des zweiten Parameters mit einem zweiten Referenzsignal, um ein Vorspann-Reduktionssignal zu erzeugen;
Zuführen des gesteuerten Vorspann-Signals an einen Vorspann-Eingang von sowohl der Treiberstufe (14) als auch der Ausgangsstufe (20);
Zuführen des Vorspann-Reduktionssignals an den Vorspann-Eingang von der Treiberstufe (14), um die durch das gesteuerte Vorspann-Signal bereitgestellte Vorspannung zu reduzieren, so dass der Ausgang von dem Leistungsverstärker geschützt wird.

2. Verfahren zum Steuern einer Ausgabe von einem Leistungsverstärker nach Anspruch 1, bei welchem der erste elektrische Parameter ein elektrischer Strom ist.

3. Verfahren zum Steuern einer Ausgabe von einem Leistungsverstärker nach Anspruch 1, bei welchem der zweite elektrische Parameter eine Ausgangs-Spannungseinhüllende ist.

4. Elektrische Schaltung, welche enthält:
einen Leistungsverstärker (10), wobei der Leistungsverstärker (10) eine Treiberstufe (34) und eine Ausgangsstufe (38) enthält;
eine externe Steuerschleife, wobei die externe Steuerschleife enthält:
ein Erfassungsmittel (42) zum Erfassen eines ersten elektrischen Parameters an einem Ausgang von der Ausgangsstufe (38);
einen ersten Referenzsignal-Generator (44) zum Erzeugen eines ersten Referenzsignals;
ein Vorspannmittel (48) zum Empfangen des ersten Referenzsignals und zum Zuführen eines gesteuerten Vorspann-Signals an einen Vorspann-Eingang von sowohl der Treiberstufe (34) als auch der Ausgangsstufe (38) in Ansprechen auf den erfassten ersten elektrischen Parameter und das erste Referenzsignal;
eine Schutzschaltung, wobei die Schutzschaltung enthält:
ein Erfassungsmittel (50) zum Erfassen eines zweiten elektrischen Parameters an einem Ausgang von der Ausgangsstufe (38);
einen zweiten Referenzsignal-Generator (52) zum Erzeugen eines zweiten Referenzsignals;
ein Vorspann-Reduktionsmittel (54) zum Empfangen des zweiten Referenzsignals und zum Zuführen eines Vorspann-Signals an den Vorspann-Eingang von der Treiberstufe (34) in Ansprechen auf den erfassten zweiten elektrischen Parameter und das zweite Referenzsignal, um das gesteuerte Vorspann-Signal zu reduzieren.

5. Mobiltelekommunikationsvorrichtung, welche die Leistungsverstärkungsschaltung nach Anspruch 4 enthält.

## Revendications

1. Procédé de commande de la sortie d'un amplificateur de puissance (10) possédant un étage d'attaque (14) et un étage de sortie (20), le procédé comprenant les étapes consistant à :
détecter un premier et un second paramètre électrique sur une sortie de l'étage de sortie (20) ;
traiter le premier paramètre avec un premier signal de référence afin de produire un signal de polarisation contrôlée ;
traiter le second paramètre avec un second signal de référence afin de produire un signal de réduction de la polarisation ;
injecter le signal de polarisation contrôlée sur une entrée de polarisation à la fois de l'étage d'attaque (14) et de l'étage de sortie (20) ;
injecter le signal de réduction de la polarisation sur l'entrée de polarisation de l'étage d'attaque (14) afin de réduire la polarisation fournie par le signal de polarisation contrôlée, afin que ladite sortie dudit amplificateur de puissance soit protégée.

2. Procédé de commande de la sortie d'un amplificateur de puissance selon la revendication 1, dans lequel le premier paramètre électrique est un courant électrique.

3. Procédé de commande de la sortie d'un amplificateur de puissance selon la revendication 1, dans lequel le second paramètre électrique est une enveloppe de tension de sortie.

4. Circuit électrique comprenant :
un amplificateur de puissance (10), l'amplificateur de puissance (10) comprenant un étage d'attaque (34) et un étage de sortie (38) ;
une boucle de commande extérieure, la boucle de commande extérieure comprenant :
un moyen de détection (42), destiné à détecter un premier paramètre électrique sur une sortie de l'étage de sortie (38) ;
un premier générateur de signal de référence (44), destiné à produire un premier signal de référence ;
un moyen de polarisation (48), destiné à recevoir le premier signal de référence et à injecter un signal de polarisation contrôlée sur une entrée de polarisation à la fois de l'étage d'attaque (34) et de l'étage de sortie (38) en réponse au premier paramètre électrique détecté et au premier signal de référence ;
un circuit de protection, le circuit de protection comprenant :
un moyen de détection (50), destiné à détecter un second paramètre électrique sur une sortie de l'étage de sortie (38) ;
un second générateur de signal de référence (52), destiné à produire un second signal de référence ;
un moyen de réduction de la polarisation (54), destiné à recevoir le second signal de référence et à injecter un signal de polarisation sur l'entrée de polarisation de l'étage d'attaque (34), en réponse au second paramètre électrique détecté et au second signal de référence, afin de réduire le signal de polarisation contrôlée.

5. Dispositif de télécommunication portable comprenant le circuit d'amplification de puissance selon la revendication 4.
